# EUROPEAN PATENT APPLICATION

(11) **EP 4 835 394 A1**
(43) Date of publication of application: **04.11.2026**
(21) Application number: 26174670.5
(22) Date of filing: 27.04.2026
(51) Int. Cl.: G01B 9/02004, G01S 7/481, G01S 7/497, G01S 7/4911, G01S 7/4912, G01S 17/34, H01S 5/06, H01S 5/183

(54) **LOW NOISE TUNABLE LASER SENSING**

(30) Priority: 28.04.2025 US 202563796104 P
(71) Applicant: Thorlabs, Inc., Newton, NJ 07860 (US)
(72) Inventor: Burgner, Christopher, Newton, NJ, 07860 (US); Jayaraman, Vijaysekhar, Newton, NJ, 07860 (US)
(74) Representative: Grättinger Möhring von Poschinger Patentanwälte Partnerschaft mbB

(57) **Abstract**

A system for optical frequency domain reflectometry (OFDR) configured to interrogate a property of an object or of a structure along a sensing optical path, comprising: a tunable VCSEL having an optical cavity with a free spectral range, said vertical cavity laser emitting periodically wavelength swept laser radiation. Said periodically wavelength swept laser radiation is directed to a sensing interferometer comprising a sensing optical path having a sensing optical path length and a reference optical path having a reference optical path length, said reference path optical length differing from said sensing optical path length by a sensing interferometer optical path difference and, wavelength swept laser radiation traversing said reference optical path is interfered with wavelength swept laser radiation traversing said sensing optical path on an optical detector generating interference fringes having a maximum fringe frequency, and said frequency slew rate is less than 5GHz/usec.

## Description

### CROSS REFERENCES TO RELATED APPLICATIONS

This application claims the benefit of U.S. Provisional Patent Application No. 63/796,104, filed on April 28, 2025, the contents of each of which are incorporated herein by reference.

### STATEMENT REGARDING FEDERALLY SPONSORED RESEARCH OR DEVELOPMENT

This invention was made under NASA contract 80NSSC23CA141. The U.S. government has certain rights in this invention.

### TECHNICAL FIELD

The present disclosure relates to fiber optic sensing (FOS) systems, optical frequency domain reflectometry (OFDR) systems, light detection and ranging (LIDAR) systems, tunable light sources, tunable vertical cavity lasers, and wavelength-swept light sources.

### BACKGROUND

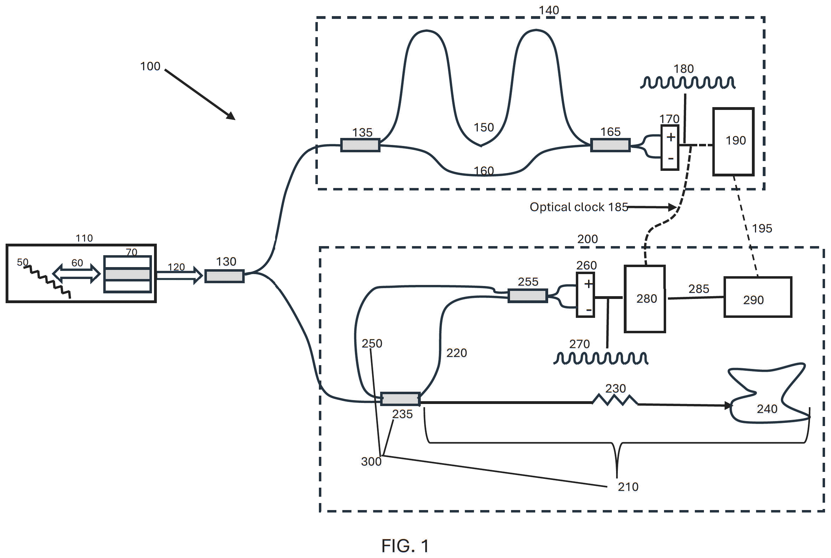

The rapidly growing field of fiber optic sensing (FOS) began in the 1960s, not long after the invention of the optical fiber. FOS sensing can be used to make single point measurements extrinsic to the fiber itself, or can be employed for distributed sensing measurements using intrinsic changes to fiber properties along its length. One version of FOS, also called optical frequency domain reflectometry (OFDR), employs a tunable laser which is repetitively swept in wavelength (equivalently swept in optical frequency) to interrogate a property of an object or a structure along a sensing optical path of an interferometer. FIG. 1 shows a simplified schematic of an OFDR system 100. Wavelength swept radiation 120 emerges from an external cavity tunable laser (ECTL) 110, comprising a gain chip 70, emitting intracavity radiation 60 which reflects off a rotating grating 50 to generate the wavelength swept output radiation 120. The wavelength swept laser radiation 120 is split by a coupler 130 to reference Mach-Zehnder interferometer (MZI) 140 and an OFDR interferometer 200. The reference MZI can also be configured as a Michaelson interferometer. The term "MZI" is understood to refer to either a Mach Zehnder or Michaelson interferometer, or another type of interferometer that implements an equivalent function. The MZI 140 comprises a shorter optical path 160 and a longer optical path 150 with an MZI optical path length difference between them. Light traversing shorter optical path 160 is combined with light traversing longer optical path 150 through a coupler 165 and interfered on a balanced detector 170, generating interference fringes 180. Operation of balanced detectors is described for example in G. Abbas, V. Chan, and T. Yee, "Local-oscillator excess-noise suppression for homodyne and heterodyne detection, " Optics letters, vol. 8, no. 8, pp. 419-421, 1983*.*

Interference fringes 180 can be used as an optical clock 185 to directly clock an analog to digital (A-D) converter 280 in the OFDR interferometer 200. This approach is referred to as optical clocking, as described for example in B. Potsaid et al., "Ultrahigh speed 1050nm swept source / Fourier domain OCT retinal and anterior segment imaging at 100,000 to 400,000 axial scans per second, " Optics Express, vol. 18, no. 19, pp. 2002920048, Sep 2010*,* with respect to swept source optical coherence tomography (SS-OCT). Alternatively, the fringes 180 can be digitized by an A-D converter 190 in the MZI interferometer 140, generating digitized MZI fringes 195 which are sent to a processor 290 for calibration of the wavelength sweep and resampling of a fringe pattern 270 in the OFDR interferometer 200. This approach is referred to as dual channel acquisition, and is described for example in J. Zhang et al., "Multi-MHz MEMS-VCSEL swept-source optical coherence tomography for endoscopic structural and angiographic imaging with miniaturized brushless motor probes, " Biomedical Optics Express, vol. 12, no. 4, pp. 23842403, 2021*,* also with respect to SS-OCT.

The OFDR interferometer 200 comprises a reference optical path 220 with a reference optical path length and a sensing optical path 300 with a sensing optical path length, which differ from each other by a sensing interferometer optical path difference. The sensing optical path 300 comprises an optical path section 210, a coupler 235, and optical path section 250, along which reflections from either a distributed sensing element 230 or an extrinsic sample 240 travel before combining with light traversing reference path 220 through a coupler 255. Inventors define the sensing optical path length as the maximum path traveled along the sensing path, encompassing the most distant reflections of interest along that path. The light combined by coupler 255 is detected by a balanced detector 260 generating sensing interferometer interference fringes 270 having a maximum fringe frequency, which are digitized by a sensing analog to digital (A-D) converter 280, generating digitized sensing interferometer fringes 285 that are sent to the processor 290. The processor 290 uses incoming signals 285 and 195 to extract properties of an object or structure along the sensing optical path 300.

The required MZI optical path difference in the MZI interferometer 140 depends on whether optical clocking of the A-D converter 280 through the optical clock signal 185 is employed or if dual channel acquisition is used, with both approaches described above. In the case of optical clocking, the MZI optical path difference should be configured to produce fringes 180 with a fringe frequency that is at least twice a maximum fringe frequency of the fringes 270. This satisfies the Nyquist sampling criterion. In the case of dual channel acquisition, however, the fringe frequency of the fringe 180 can be than the maximum fringe frequency of the fringe 270.

The OFDR system 100 pictured in FIG. 1 can be used to determine properties of an object 240 at the end of the sensing optical path section 210. It can be also be used to determine perturbations along the fiber path through an integrated passive sensing element, such as a grating 230 inscribed into a fiber along the sensing optical path section 210. The magnitude of strain, for example, at the grating 230 can be detected as a change in the reflection band of the grating due to change in the spacing of grating grooves. Using multiple gratings or a long grating with a period varying along the sensing optical path section 210 can be used to implement for example distributed strain sensing along the path 210. In most cases, the optical paths 150, 160, 220, and 300 shown are implemented in fiber but they could also be implemented in free space or some other medium. Throughout this specification, the term OFDR is understood to encompass both fiber-based and free-space systems, including LIDAR systems.

The OFDR system 100 uses the ECTL 110 as a critical part of the system 100. The properties of the ECTL 110 affect properties of the system 100. Advantages of the ECTL-based system 100 include a <100kHz narrow linewidth in the ECTLs which enables >1km coherence length and sensing over >1 kilometer distances. A disadvantage of the system 100 is that mechanical rotation of the grating 50 constrains wavelength (equivalently frequency) slew times to the order of seconds over full tuning range. Another disadvantage of the system 100 is that critical intra-cavity mechanical alignments in the ECTL 110, as well as large size, weight, and power (SWAP) requirements, limit the system 100 to ground-based or low-vibration environments.
Discrete assembly required for ECTLs also limits volume scalability and prohibits arraybased applications. For these reasons, OFDR using the system 100 has achieved limited proliferation and adoption.

The above limitations of ECTLs can potentially be overcome by emerging micro-electromechanical systems tunable vertical cavity surface emitting lasers (MEMSVCSELs). For clarity, by MEMS-VCSELs inventors mean any tunable VCSEL that has a suspended mirror and a tunable airgap tuned by an electrical drive. Change of the airgap changes the lasing wavelength. The acronym VCSEL is also understood to encompass vertical cavity lasers which can be surface-emitting (equivalently top-emitting) or bottomemitting. MEMS-VCSELs are a leading widely and rapidly tunable wavelength-swept laser for swept source optical coherence tomography (SS-OCT), with frequency slew rates that are many orders of magnitude faster than ECTLs. The operating principles of SS-OCT are similar to those of OFDR. The short micron scale cavity in MEMS-VCSELs produces only one longitudinal mode near the peak of the material gain spectrum, facilitating modehop free continuously tuned single mode operation. Single longitudinal mode operation has been demonstrated to produce few MHz linewidths and multi-meter coherence lengths in fixed wavelength VCSELs. Typical required OFDR tuning ranges for center wavelengths in the wavelength range of 1500-1600nm are 20nm-150nm. The MEMS-VCSEL satisfies this requirement as well, as shown for example V. Jayaraman, et al, "High sweep-rate 1310nm MEMS-VCSEL with 150nm continuous tuning range," Electronics Letters, volume 48, no. 14, July 5, 2012, pp. 867-879*.* Inventors note that OFDR could be accomplished over tuning ranges of less than 20nm, using for example bias-current tuned VCSELs such as for example M. Kendrisic et al., "Exploring single-mode VCSEL wavelength tuning for lowcost 3D optical coherence tomography and OCT angiography, " Biomedical Optics Express, vol. 15, no. 8, pp. 4719-4736, 2024*.* The small chip size and monolithic fabrication enable >5000 devices in a single fabrication run on a 3-inch wafer. This wafer scale fabrication, coupled with automated wafer-scale testing, greatly reduces manufacturing cost relative to ECTL devices and enables volume scalability. This also enables array applications. Additionally MEMS devices such as accelerometers, gyroscopes, and pressure sensors have a long history of successful ruggedization for harsh avionic environments, suggesting it is possible to ruggedize MEMS-VCSELs for OFDR in harsh or high vibration environments. Lastly, the low size, weight, and power (SWAP) of MEMS-VCSELs facilitate use in flight-borne applications.

A significant barrier preventing the use of MEMS-VCSELs for OFDR, however, is the presence of suspended membrane thermal noise or Brownian motion, which broadens the intrinsic MEMS-VCSEL linewidth and degrades OFDR fringe quality. For the tens or hundreds of kHz sweep rates used for SS-OCT at centimeter distance scales, Brownian motion does not degrade performance, since the speed of the laser wavelength sweep overwhelms the frequency slew rate noise caused by Brownian motion. The negative impact of Brownian motion, however, is exacerbated at the slower sweep rates (typically sub-kHz) that are necessary to maintain sub-GHz fringe frequencies at multimeter sensing distances for OFDR. Sub-GHz fringe frequencies are desirable to enable the use of more economical and widely available A-D converters with <1 GHz sampling rates. The velocity noise or equivalently frequency slew rate noise arising from Brownian motion ultimately limits sensing accuracy and sensing distance.

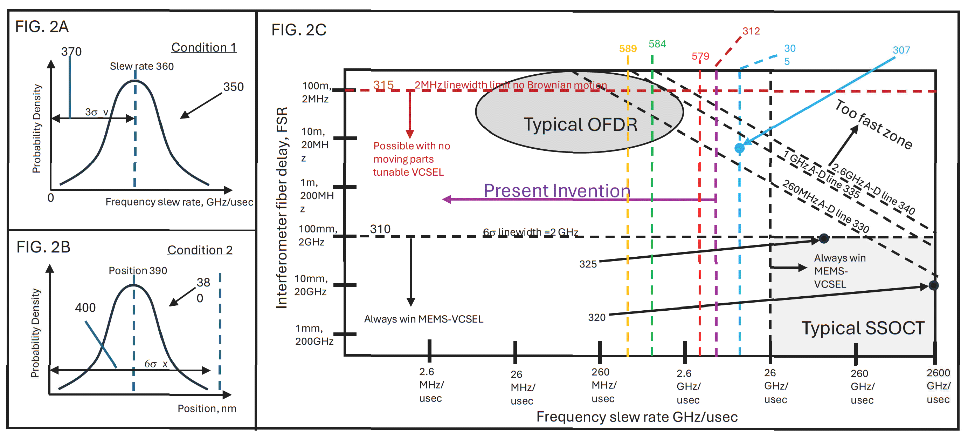

FIG. 2 aids in describing in more detail the challenges of adapting MEMSVCSELs for OFDR. FIGS. 2A and 2B represent two alternate approximate conditions by which a wavelength-swept MEMS-VCSEL can succeed for a particular application, and FIG. 2C represents various regimes of frequency slew rate and interferometer delay representing different applications. FIG. 2A represents condition 1, and shows a probability density function (PDF) 350 of frequency slew rate, typically expressed here in Gigahertz/microsecond (GHz/usec), for a MEMS-VCSEL. In order to succeed at condition 1, the MEMS-VCSEL must be operated at a slew rate 360 that exceeds a single-sided three sigma value 370 of the PDF 350. Inventors refer to the three sigma value 370 as the quantity 3σ_v. This condition makes it unlikely that the fringe velocity crosses zero, which would degrade fringe quality significantly. FIG. 2B represents condition 2, and shows a PDF 380 of the position of the suspended mirror, represented for example in nanometers, for a MEMS-VCSEL. In order to succeed at condition 2, a 6 sigma double-sided value (6 σ_x) 400 around a membrane nominal position 390, must not broaden VCSEL linewidth beyond the FSR of the longest interferometer used in an OFDR system, whether that be the MZI interferometer 140 in FIG. 1, or the sensing interferometer 200 in FIG. 1. The 6 σ_x value is chosen to approximate integration of the Brownian motion over essentially infinite time. Typical MEMS-VCSELs have long-time integrated linewidths on the order of 200400MHz, as discussed in for example H. Halbritter, C. Sydlo, B. Kogel, F. Riemenschneider, H. L. Hartnagel, and P. Meissner, "Linewidth and chirp of MEMSVCSELs," (in English), IEEE Photonics Technol. Lett., Article vol. 18, no. 17-20, pp. 21802182, Sep-Oct 2006*,* so 6σ linewidth is on the order of 2 GHz, corresponding to tens of picometers of membrane motion for the 6 σ_x value. Under condition 2, the VCSEL could not be operated with an interferometer with FSR less than 2 GHz, or in terms of interferometer path delay not longer than about 100mm in optical fiber. Condition 2 is more stringent than Condition 1 as examination of FIG. 2C will show.

FIG. 2C represents various regimes of frequency slew rate and interferometer optical path delay for various potential applications of MEMS-VCSELs. The horizontal axis of FIG. 2C is frequency slew rate in GHz/usec. This parameter can be used to compare MEMS-VCSELs operating at different center wavelengths and different tuning ranges. The vertical axis is the interferometer fiber delay, or equivalent optical path difference in fiber in the longer of the two interferometers in FIG. 1. Longer interferometer delays enable longer sensing distances. The region below the horizontal dashed black line 310 in FIG. 2C satisfies condition 2 represented in FIG. 2B. Regions to the right of the various vertical dashed lines in FIG. 2C satisfy condition 1 if the 3σ_v value of the wavelength swept source employed is less than the GHz/usec value represented by the vertical dashed line.

An approximate range of operation for SS-OCT systems used in medical imaging is represented in the lower right square of this figure, operating at delays of <100mm and frequency slew rates of >26GHz/usec, where both condition 1 and condition 2 are satisfied for typical MEMS-VCSELs. Two example sets of operating parameters for SS-OCT systems are represented by the two black dots 320 and 325 in the shaded lower right region of FIG. 2C. The dot 320 represents an SSOCT system at 1310nm, with 115nm tuning range, 100kHz axial scan rate, 80% duty cycle and 10mm fiber delay. Such a system might be used for example in anterior eye imaging or cardiovascular imaging. The dot 325 represents an SSOCT system operating at 10 kHz axial scan rate over 30nm tuning range at 1050nm center wavelength with 80% duty cycle, and 100mm interferometer delay, such as might be used in a system for optical biometry. These ranges of parameters are wellknown to those skilled in the art of SS-OCT.

Also shown in FIG. 2C are diagonal dashed black limit lines 330, 335, and 340 representing combinations of interferometer length and slew rate in which the frequency of fringes at the output of the corresponding MZI interferometer is constant. The various lines 330, 335, 340 correspond to different speeds of A-D converter necessary to operate along or to the lower left of the dashed line. These assume Nyquist sampling, where the sampling rate must be at least twice the maximum frequency of the fringes 180 or fringes 270 represented in FIG. 1. Thus a 260MHz A-D converter, represented by the dashed line 330, corresponds to a fringe frequency of 130MHz along the line 330. Similarly a 1GHz A-D, represented by the dashed line 335, corresponds to 500MHz maximum fringe frequency, and a 2.6GHz A-D, represented by the dashed line 340, can sample up to 1.3GHz maximum fringe frequency. Fringe frequencies to the lower left of the dashed lines are lower than the frequencies along the dashed lines. Both SS-OCT systems represented by the black dots 320 and 325 generate maximum fringe frequencies less than 130MHz, and can therefore operate with 260 MHz A-D converters. Similarly, fringe frequencies in the region to the upper right of the 2.6GHz A-D converter line 340 are higher than 1.3GHz.

The approximate operating regime of OFDR is represented by the grey oval in the upper middle portion of the chart, driven in part by lower cost A-D converters operating at <1GHz, and by long interferometers with path delays in the range of a few meters to greater than 100 meters. As shown, OFDR systems typically require slew rates of around 2.6GHz/usec or less, to maintain fringe frequencies of <500 MHz at interferometer delays often exceeding 10 meters of optical fiber, to enable sampling by AD converters of <1 GHz speed. In order to use a swept source at speeds of 2.6 GHz or less, it must have a single-sided 3σ_v of less than 2.6GHz, where σ_v is the standard deviation of the frequency slew rate noise, represented in FIG. 2A.

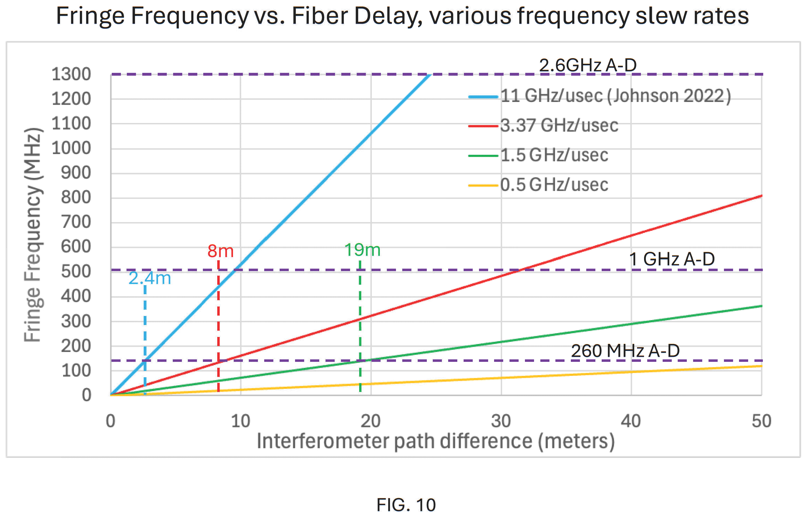

MEMS-VCSELs for SS-OCT have a 3σ_v velocity noise that is typically much larger than 2.6GHz/usec, so fail both condition 1 and condition 2 for OFDR. Some workers have explored the slew rate noise limits of existing MEMS-VCSEL designs in distance ranging applications like LIDAR, such as described for example in B. Johnson et al., "Linewidth considerations for MEMS tunable VCSEL LiDAR, " Optics Express, vol. 30, no. 10, pp. 17230-17242, 2022 *(hereafter Johnson 2022),* and also in B. Johnson et al., "Tunable 1060nm VCSEL co-packaged with pump and SOA for OCT and LiDAR," in Optical Coherence Tomography and Coherence Domain Optical Methods in Biomedicine XXIII, 2019, vol. 10867: SPIE, pp. 5-14*.* For the purpose of this disclosure, no distinction is made between free space applications like LIDAR and fiber-based applications like fiber-based strain sensing. FIG. 1 of Johnson 2022 describes a LIDAR system with a 10 meter path free-space delay (equivalent to 6.9 meter in fiber,) using a MEMS-VCSEL with a 1050nm center wavelength, 70nm tuning range, 500Hz repetition rate, unidirectional scanning, and an 86% duty cycle. As can be calculated by those skilled in the art, these parameters correspond to a frequency slew rate of 11 GHz/usec, as also indicated in FIG. 1 of Johnson 2022. This value is represented by the blue vertical dashed line 305 in FIG. 2C, and the 6.9 meter equivalent fiber optic delay is represented along the dashed blue line as the blue dot 307. As will be discussed later with respect to FIG. 10, this 11 GHz/usec slew rate limits the fiber delay to 2.4 meters for a fringe frequency of 130MHz, compatible with a lower cost A-D converter of 260MHz bandwidth. The work of Johnson 2022 required a faster A-D converter to support the 6.9 meter fiber delay (equivalent to 10 meter air delay) reported in the paper. Thus far, no slower slew rates have been reported in the literature for OFDR using MEMS-VCSELs or any tunable VCSELs for that matter. Based on FIG. 2C, making MEMS-VCSELs suitable for existing OFDR systems requires operation at 2.6GHz/usec or equivalently a 3σ_v noise value that is less than 2.6 GHz/usec. Slower slew rates enable operation at longer lengths or with lower speed A-D converters. Slew rates <5GHz/usec may also be useful as the higher speed A-D converters become more widely available. This 5GHz/usec is represented by the maroon vertical dashed line 312 in FIG. 2C, and is the boundary of the present disclosure as described below, representing a greater than factor of 2 slew rate improvement over the related art of Johnson 2022.

Reducing the minimum frequency slew rate that can be employed in a MEMS-VCSEL based OFDR system requires reducing the Brownian motion induced velocity noise on MEMS-VCSELs or employing tunable VCSELs with sufficient tuning range for OFDR that employ alternate tuning mechanisms. A low Brownian motion tunable VCSEL would enable new system parameters and system applications not possible with ECTLs, such as vibration sensitive environments and airborne or space-borne applications requiring low size, weight, and power. The array capability of VCSELs also suggests more sophisticated fiber-optic sensing configurations covering larger areas than possible with external cavity tunable lasers.

From the foregoing, it is clear that what is required is a system for OFDR employing a tunable VCSEL laser source with a 3σ_v velocity noise value that is less than 5 GHz/usec, supporting slew rates less than 5 GHz/usec, and enabling array-based OFDR systems, airborne OFDR systems, and OFDR systems in high-vibration environments.

The same low-velocity noise tunable VCSEL can also be employed to probe the spectral response of a sample with narrow linewidth features, as also discussed below.

The description provided in the background section should not be assumed to be prior art merely because it is mentioned in or associated with the background section. The background section may include information that describes one or more aspects of the subject technology.

### SUMMARY

This disclosure provides preferred embodiments of OFDR systems and systems for probing the spectral response of a sample employing low Brownian motion tunable VCSELs. A preferred wavelength range is between 1500 and 1600nm, compatible with existing low loss optical fibers in this range.

A preferred embodiment of an OFDR system uses a MEMS-VCSEL with a high mass suspended mirror with electro-thermal tuning. A resistive heater integral with the mirror provides upward deflection of the mirror when driven electrically with injected current, increasing airgap and tuning to longer wavelengths. The high mass reduces velocity noise and enables slew rates less than 1 GHz/usec, supporting OFDR at >50-meter interferometer delay using an A-D rate of 1 GHz. This preferred OFDR system further comprises a sensing path with a sensing optical path length, a reference path with a reference optical path length, an optical detector to generate interference fringes with a maximum fringe frequency from reflections traveling along the sensing optical path and interfering with light traversing the reference fiber, an A-D converter to digitize the interference fringes, and a signal processing system to extract properties of an object or structure along the sensing optical path.

The slow slew rate enabled by the low velocity noise MEMS-VCSEL also enables resolution of fine spectral response features of a sample having a full width at half maximum in the megahertz (MHz) or even kilohertz (kHz) range.

Another preferred embodiment of an OFDR system uses an electrostatically tuned or electro-thermally tuned VCSEL with FSR less than about 5% of the center wavelength. The reduced FSR relative to MEMS-VCSELs used in SS-OCT reduces velocity noise while maintaining adequate tuning range.

Another preferred embodiment of a VCSEL based OFDR system uses an intracavity tunable liquid crystal for wavelength tuning.

Another preferred embodiment of a VCSEL based OFDR system uses an array of at least 2 thermally tuned VCSELs as a wavelength tunable source.

A preferred embodiment of a tunable vertical cavity laser uses a thermally tuned intracavity spacer.

### BRIEF DESCRIPTION OF THE DRAWINGS

FIG. 1 illustrates an OFDR system.
FIG. 2A illustrates a frequency slew rate noise condition that enables use of a MEMS-VCSEL in OFDR.
FIG. 2B illustrates a position noise condition that enables use of a MEMSVCSEL in OFDR.
FIG. 2C illustrates various regimes of interferometer delay and frequency slew rate corresponding to various applications.
FIG. 3 illustrates an OFDR system employing a low Brownian motion MEMS-VCSEL according to the present disclosure.
FIG. 4A illustrates a cross-sectional view of an electrostatically tuned MEMS-VCSEL.
FIG. 4B illustrates a top-view of the electrostatically tuned MEMS-VCSEL shown in FIG. 4A
FIG. 5A illustrates a cross-sectional view of an electro-thermally tuned MEMS-VCSEL used in an OFDR system according to the present disclosure.
FIG. 5B illustrates a top view of the electro-thermally tuned MEMSVCSEL in FIG. 5A.
FIG. 6A illustrates tuned laser spectra emitted from the preferred embodiment of a tunable VCSEL illustrated in FIG. 5.
FIG. 6B illustrates the wavelength and voltage vs. current in the preferred embodiment of a tunable VCSEL illustrated in FIG. 5.
FIG. 6C illustrates the emitted power vs. pump power for the preferred embodiment tunable VCSEL according to FIG. 5.
FIG. 6D illustrates the frequency response of tuning for the preferred embodiment tunable VCSEL according to FIG. 5.
FIG. 7A illustrates wavelength change vs. time arising from Brownian motion noise for 3 different tunable VCSEL structures.
FIG. 7B illustrates a probability density function of frequency slew rate noise for the 3 different tunable VCSEL structures in FIG. 7A.
FIG. 8 illustrates spectra of membrane position noise for the thermally tuned MEMS-VCSELs represented in FIG. 5 vs. electrostatically tuned MEMS-VCSELs represented in FIG. 4.
FIG. 9A illustrates interferometer configurations for testing electrothermally tuned swept source. Fig. 9B illustrates fringes near 200 MHz fringe frequency obtained in an interferometer with 5 and 80 meter path delay, using the preferred tunable VCSEL embodiment of FIG. 5.
FIG. 10 illustrates a calculation of fringe frequency vs. interferometer path delay, for various frequency slew rates.
FIG. 11 illustrates an OFDR system according to the present disclosure, using an arrayed VCSEL swept source.
FIG. 12 shows VCSEL drive current and multiplexed output for an array of two VCSELs suitable for use in the system of FIG. 11.
FIG. 13 illustrates a thermally tuned narrow linewidth VCSEL according to the present disclosure.
FIG. 14 illustrates a calculation of wavelength vs. temperature of spacer layer for the VCSEL of FIG. 13.

### DETAILED DESCRIPTION

The description of illustrative embodiments according to principles of the present disclosure is intended to be read in connection with the accompanying drawings, which are to be considered part of the entire written description. In the description of embodiments of the disclosed herein, any reference to direction or orientation is merely intended for convenience of description and is not intended in any way to limit the scope of the present disclosure. Relative terms such as "lower," "upper," "horizontal," "vertical," "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description only and do not require that the apparatus be constructed or operated in a particular orientation unless explicitly indicated as such. Terms such as "attached," "affixed," "connected," "coupled," "interconnected," and similar refer to a relationship wherein structures are secured or attached to one another either directly or indirectly through intervening structures, as well as both movable or rigid attachments or relationships, unless expressly described otherwise. Moreover, the features and benefits of the disclosure are illustrated by reference to the exemplified embodiments. Accordingly, the disclosure expressly should not be limited to such exemplary embodiments illustrating some possible non-limiting combination of features that may exist alone or in other combinations of features; the scope of the disclosure being defined by the claims appended hereto.

This disclosure describes the best mode or modes of practicing the embodiment as presently contemplated. This description is not intended to be understood in a limiting sense, but provides an example of the embodiment presented solely for illustrative purposes by reference to the accompanying drawings to advise one of ordinary skill in the art of the advantages and construction of the embodiment. In the various views of the drawings, like reference characters designate like or similar parts.

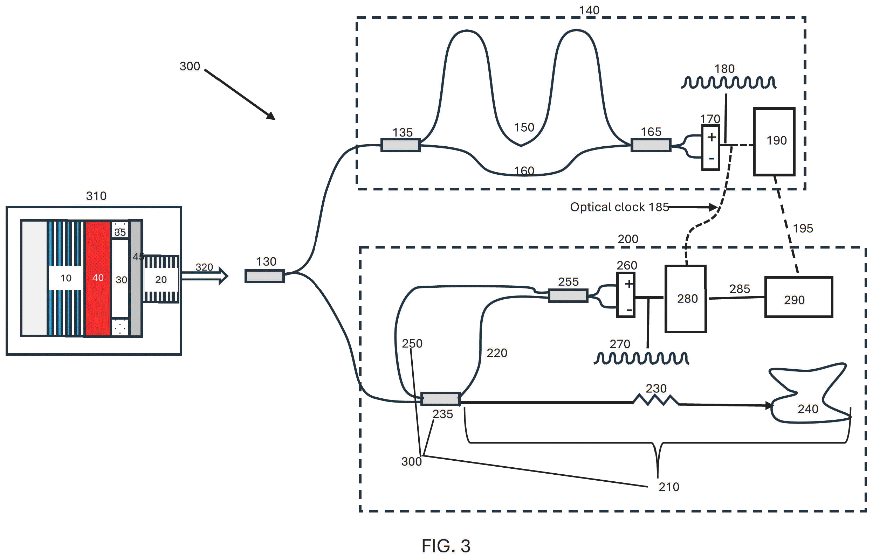

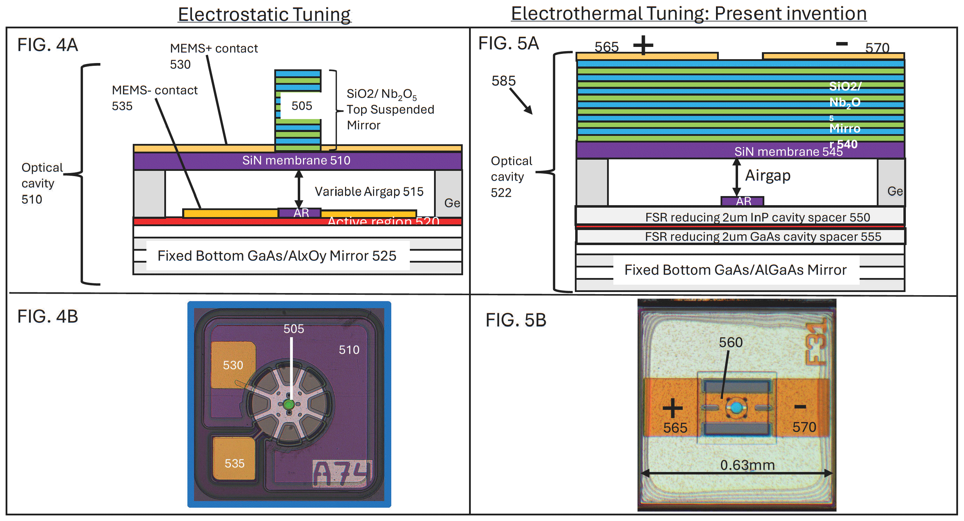

FIG. 3 shows an OFDR system 300 according to the present invention, employing a low Brownian motion MEMS-VCSEL 310 comprising a suspended mirror 20 suspended on a membrane 45 above an airgap 30, a gain region 40, and a bottom mirror 10. The noise characteristics of the MEMS-VCSEL 310 affect several key parameters of the system 300, such as interferometer delays, A-D converter sampling rate, and maximum sensing distance. Operating parameters of the MEMS-VCSEL 310 are affected by the specifics of the design as discussed below with respect to FIGS. 4-9.

FIG. 4A illustrates a cross-sectional view of a related art MEMS-VCSEL using electro-static tuning. This structure is similar to a related art 1310nm MEMS-VCSEL described in V. Jayaraman, G. D. Cole, M. Robertson, A. Uddin, and A. Cable, "Highsweep-rate 1310 nm MEMS-VCSEL with 150 nm continuous tuning range," Electron. Lett., vol. 48, no. 14, pp. 867-9, 5 July 2012. As shown in FIG. 4A, an optical cavity 510 comprises a top suspended mirror 505 on a silicon nitride (SiN) membrane 510 above a variable airgap 515. Beneath the airgap is the VCSEL active region 520, underneath which is a fixed multilayer bottom mirror 525. The optical cavity 510 has a typical free spectral range that is 8-10% of the center wavelength. Typical materials employed at 1550nm include aluminum indium gallium arsenide (AlInGaAs) quantum wells for the active/gain region 520, Gallium Arsenide/Aluminum Oxide (GaAs/AlₓO_{y}) for the fixed bottom mirror 525 and silicon dioxide/niobium pentoxide (SiO2/Nb2O5) for the suspended top mirror 505. The structure is tuned electrostatically by application of a voltage between the MEMS+ contact 530 and MEMS- contact 535. This leads to contraction of the airgap and tuning to shorter wavelengths. FIG. 4B shows a top-view of the same structure. This structure is designed to operate in the OCT regime at the lower right of FIG. 2C, but due to low suspended mirror and membrane mass and Brownian motion, suffers from frequency slew rate noise and poor fringe quality when applied to OFDR.

FIG. 5A shows a cross-sectional view of a low velocity noise tunable VCSEL 585 with optical cavity 522 to be used as the tunable laser 310 in the OFDR system 300 according to the present invention, while FIG. 5B shows a top view of the VCSEL in 5A. Here, an SiO2/Nb2O5 mirror 540 extends over a large area of a SiN membrane 545, rather than being restricted to a central region as in FIG. 4A, increasing the mass of the suspended mirror and membrane structure by several times and reducing velocity noise. Additionally, the structure includes a 2 micron thick Indium Phosphide (InP) cavity spacer layer 550 and 2 micron thick Gallium Arsenide (GaAs) cavity spacer layer 555, which reduces FSR and further reduces velocity noise. The relationship between standard deviation of velocity noise σ_v (equivalent to frequency slew rate noise), FSR, and actuator mass m is given by σ_v ~(2|FSR|/λ) x sqrt(K_{B}T/m), where λ is the wavelength of operation and K_{B} is Boltzmann's constant. The optical cavity 522 of FIG. 5 has an FSR near 45nm at an operating wavelength in the range of 1500-1600nm, which is considerably lower than the FSR of a typical MEMS-VCSEL in this wavelength range, which is around 140nm. FSR limits tuning range, but OFDR applications can function with lower tuning range than SS-OCT and minimizing FSR minimizes the velocity noise for a given tuning range. The preferred FSR for the tunable MEMS-VCSEL in an OFDR system according to the present invention is <5% of the center wavelength.

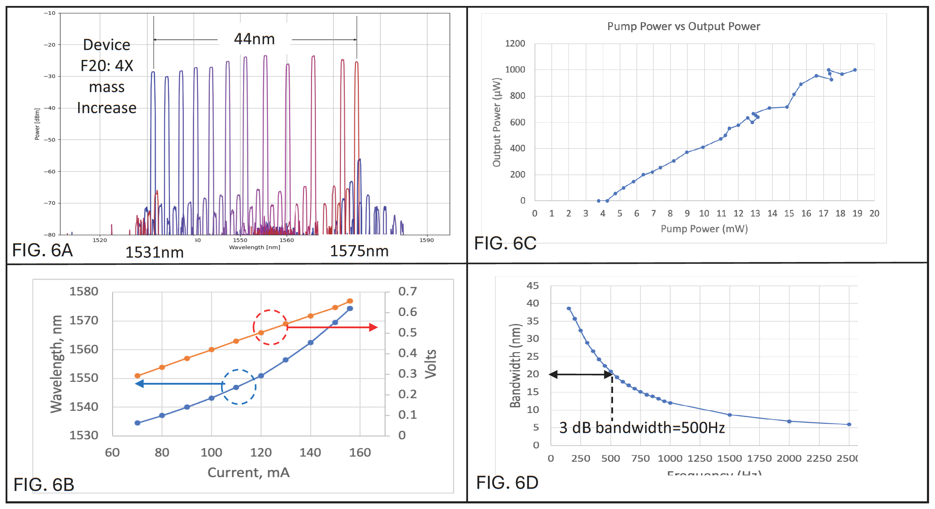

Electrostatic tuning of the structure 585 in FIG. 5 would require prohibitively high voltages to deflect the stiff and thick mirror/membrane combination. Electro-thermal tuning, however, can be employed, such as that used in C. Gierl et al., "Surface micromachined tunable 1.55 mu m-VCSEL with 102 nm continuous single-mode tuning," Optics Express, vol. 19, no. 18, pp. 17336-17343, Aug 29 2011*.* In FIG. 5A,B, current is passed along a resistive metal 560 at the top of the DBR, between a positive contact 565 and a negative contact 570, as indicated in FIGS. 5A and 5B. This flowing current heats the membrane and deflects it upward, increasing the airgap and tuning the laser to longer wavelengths. FIG. 6A shows optical spectra over 44nm tuning range and FIG. 6B shows wavelength as a function of current and voltage applied to the heating element on top of the DBR. As shown in FIG. 6C,which shows output power as a function of input power, these devices emit up to 1 mW of output power. FIG. 6D shows that the frequency response of tuning has a 3dB bandwidth of about 500Hz, which is orders of magnitude slower than MEMS-VCSELs for SS-OCT, but consistent with the sweep speeds required for OFDR over multi-meter distances generating fringes with less than about 500 MHz frequency, and therefore capable of being sampled by A-D converters with 1GHz or less sampling rates. This will be discussed further later with respect to FIG. 10 below.

The present invention tunable VCSEL 585 pictured in FIGS. 5A and 5B includes both low FSR and high mass with electro-thermal tuning, but the present invention could include one element and not the other and still be useful for some regimes of OFDR operation. FSR less than about 5% of the center wavelength of tuning can still provide lower velocity noise than a typical MEMS-VCSEL even without the high mass actuator and electro-thermal tuning. Similarly, use of a high mass actuator with electro-thermal tuning without the lower FSR can also provide velocity noise reduction. The combination of low FSR and high actuator mass, however, minimizes the frequency slew rate noise.

The tunable VCSEL of FIG. 5 is a critical component in the OFDR system 300 according to the present invention in FIG. 3, producing higher quality fringes and enabling greater interferometer path delays and greater sensing distances than possible with the system described in Johnson 2022. These are possible because of the low velocity noise of the tunable VCSEL in FIG. 5.

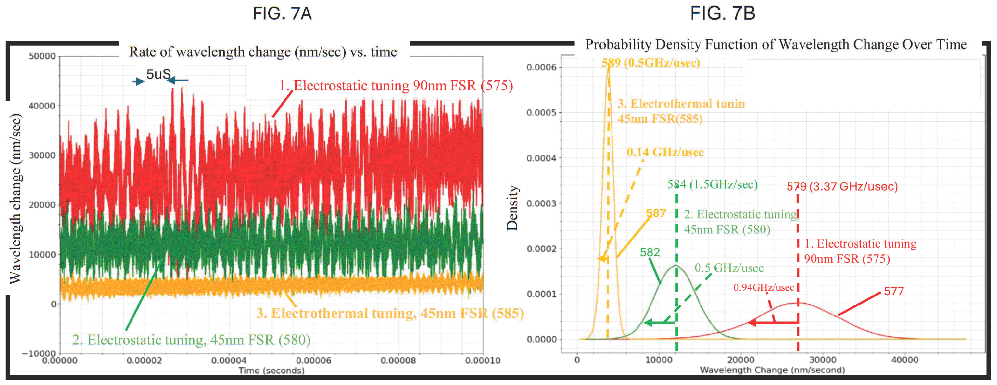

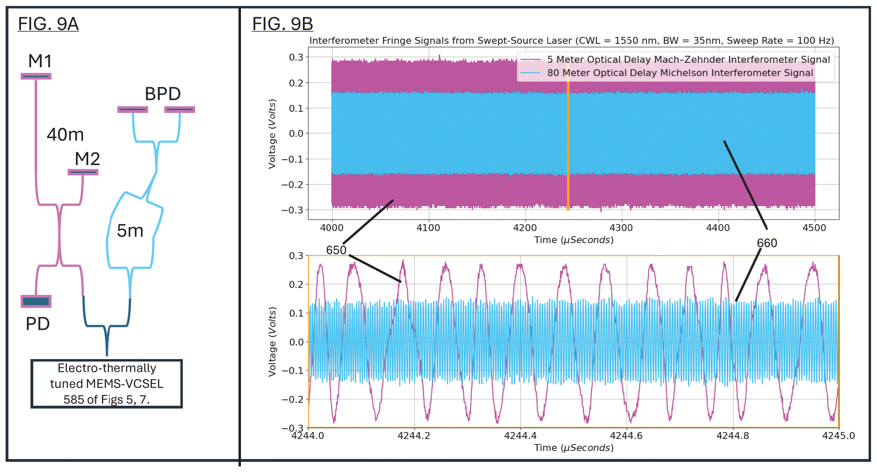

FIGS. 7-8 illustrate quantitatively the performance of three different generations of the low Brownian motion MEMS-VCSELs that can be incorporated as critical elements of the present invention system 300. FIG. 7 compares the velocity noise for these three designs, including the tunable VCSEL 585 of FIG. 5 tested for fringe quality in FIG. 9. FIG. 7A shows the rate of wavelength change nm/sec vs. time, indicating the presence of random fluctuations which inventors refer to as frequency slew rate noise. The units of nm/sec can be converted for convenience to GHz/usec, as inventors have done in FIG. 7B, for ease of comparison with related art in FIG. 2C. As shown, a 90nm FSR electrostatically tuned structure 575, a 45nm FSR electrostatically tuned structure 580, and a 45nm FSR electrothermally tuned structure 585 (585 also shown in FIG. 5) vary significantly in the amount of velocity noise present. The structure 580 employs the same optical cavity 522 as the structure 585 shown in FIG. 5, except that the top of the structure is replaced with an electrostatically tuned mirror as in FIG. 4. FIG. 7B plots the probability density function (PDF) of the velocity noise for these same three structures and indicates the standard deviation σ_v of this velocity noise. This horizontal axis is plotted as nm/sec, but inventors have converted this GHz/usec as shown for specific points of operation. The 90nm FSR structure 575 is an electrically pumped MEMS-VCSEL and has a PDF 577 shown in FIG. 7B, with a single-sided standard deviation width σ_v of its frequency slew rate noise PDF of about 0.94GHz/usec. When operated at a frequency slew rate at least 3 times this, such as the 3.37GHz/sec indicated by the red vertical dashed line 579, this MEMS-VCSEL satisfies the rule of slewing faster than 3σ_v, represented as condition 1 in FIG. 2A The 45nm FSR structure 580 has a PDF 582 with a σ_v of about 0.5 GHz/usec. The structure 580 can therefore satisfy condition 1 of FIG. 2A by slewing at a minimum rate of 1.5 GHz/usec, shown by the dashed line 584. The structure 585 has the PDF 587 with the lowest frequency slew rate noise, using the electrothermally tuned design of FIG. 5, having σ_v of about 0.14 GHz/usec. Slewing the structure 585 at 0.5GHz/sec, represented by the vertical dashed line 589 easily satisfies condition 1 of FIG. 2A.

The three slew rates representing the 3 generations of MEMS-VCSEL are represented by the vertical dashed lines 579, 584, 589 in FIG. 7B, representing 3.37GHz/usec, 1.5 GHz/usec, and 0.5 GHz/usec, respectively. These same three slew rates are represented also by dashed lines of the same numbers 579, 584, and 589 in FIG. 2C. As shown, these are all slewing considerably slower than the work of Johnson 2022 represented by the line 305 in FIG. 2C. In FIG. 2C, inventors define the zone of the present invention as slew rates slower than about 5 GHz/usec, or more than a factor of 2 better than the related art of Johnson 2022 and encompassing all three designs shown in FIGS. 7A and 7B. Inventors obtain this performance by increased mass of the suspended actuator and/or reduced FSR of the cavity.

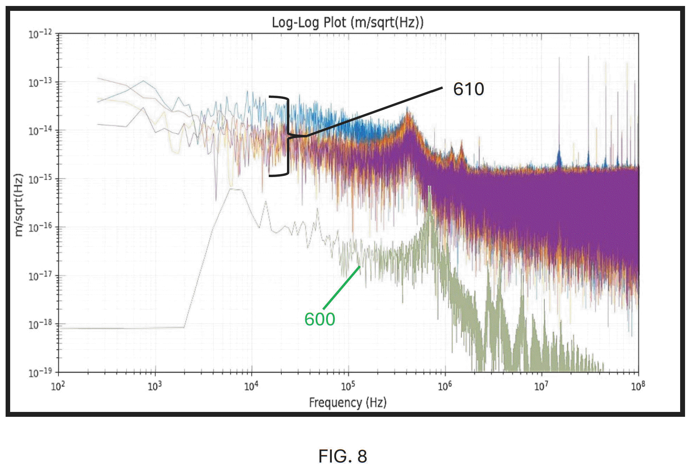

FIG. 8 represents differently the Brownian motion advantage of the electrothermally tuned high mass design over the electrostatic designs. The curve 600 of FIG. 8 shows the position noise of the actuator for the structure 585 of FIGS. 5 and 7, in meters/Hz^{1/2}, showing >10 dB reduction relative to the structures 575 and 580 of FIG. 7B and represented by the curves 610 in FIG. 8.

The tunable VCSEL 585 shown structurally in FIG. 5 and characterized by the PDF 587 in FIG. 7B and slew rate 589 in FIGS. 7B and 2C is in fact capable of generating clean fringes at sub-GHz frequencies at interferometer path differences up to 80 meters, about a factor of 11.6 longer than that of Johnson 2022. FIG. 9A shows the configuration of an 80meter delay Michaelson interferometer and 5-meter delay MZI. The 80-meter Michaelson interferometer uses double pass in the interferometer arms through reflections off mirrors M1 and M2 so 40-meter single pass path difference corresponds to 80-meter delay. FIG. 9B shows fringes obtained from both interferometers, with the pink fringes 650 obtained from the 5-meter MZI and the blue fringes 660 corresponding to those from the 80-meter delay Michaelson. The data of Fig 9B were obtained using an optically pumped version of the tunable VCSEL structure of FIG. 5 designed for a center wavelength of 1550nm, an FSR of 45 nm, a top suspended mirror comprised of 8.25 periods of SiO2/Nb2O5 on a ¾ wavelength thick silicon nitride membrane, and a 36-period GaAs/Al(0.92)Ga(0.08)As bottom mirror. A 2um cavity spacer (2um of GaAs on one side and 2um of InP on the other side) was employed on both sides of the active/gain region to reduce the FSR. This is in fact the structure 585 referenced in Figs 5 and 7. The laser was tuned at a repetition rate of 100 Hz over 35nm tuning range. This generated approximately 13 MHz fringes at 5 meters (pink) and ~208 MHz fringes at 80-meters. Both path delays demonstrated clean fringes, though some residual noise on the fringe is visible in the 5meter MZI fringes similar to that observed in FIG. 2 of Johnson 2022, but at much slower slew rate and much longer path delay than Johnson 2022. Similar noise would be expected on the 80-meter delay fringes in FIG. 9B but is not as visible due to the lower resolution of the latter plot.

FIG. 10 illustrates quantitatively the value of operating at lower frequency slew rates in enabling longer interferometer path delays and therefore longer sensing distances. The horizontal axis represents interferometer path difference in meters of optical fiber, and the vertical axis is fringe frequency. The various lines plotted represent the 3 designs in FIG. 7, as well as the related art of Johnson 2022. The colors used are the same as in FIGS. 2C and 7. As shown, the Johnson 2022 related art (blue) which uses 11GHz/usec slew rate, is capable of a supporting a delay up to 2.4 meters, while keeping fringe frequency below 130 MHz to enable using a 260 MHz A-D converter. By contrast, the 3.37 GHz/usec slew rate corresponding to structure 575 in FIGS. 2 and 7 (red) and 1.5 GHz/usec slew rate corresponding to structure 580 in FIGS. 2 and 7 (green) shown in FIG. 10 support interferometer path differences of 8 meters and 19 meters, respectively at 260 MHz A-D rate. The electro-thermally driven design of FIGS. 5 and 7 (structure 585) supports delays in excess of 50meters at 260MHz A-D sampling rate (yellow). Depending on whether optical clocking or dual channel acquisition is used in the OFDR system (see FIGS. 1 and 3), these path delays could correspond to sensing distances that are either a factor of 2 smaller (optical clocking) or the same as the interferometer delays shown in FIG. 10. Similar comparisons can be made for the faster A-D converters shown in FIG. 10.

Another preferred embodiment of the present invention is a system for characterizing a spectral response of a sample having fine spectral features. The system includes a low velocity noise MEMS-VCSEL capable of operating at frequency slew rates of <5 GHz/usec, emitting tuned laser radiation having a center wavelength and a wavelength range and directed at the sample, an optical detector to capture tuned laser radiation transmitted, reflected or scattered by the sample, and signal processing to convert the detected light signal to a spectral response function of the sample. Inventors use the term "system" to encompass also any subsystem that includes the MEMS-VCSEL plus at least one other component, such as, for example drive electronics for the laser, or an A-D converter to digitize the optical detector signal. By "sample" inventors include anything under spectral test, including devices like photonic integrated circuits, components used in wavelength division multiplexed optical communications, optical filters, and other devices having a response that is a function of wavelength. For example, a ring resonator commonly employed for wavelength locking of lasers may have spectral features that have a full width at half maximum (FWHM) of 1 MHz to 100 MHz. Digitizing 10 points on a 100MHz feature (10 MHz spacing) at a frequency slew rate of 5Ghz/usec requires an A-D converter operating at 500MHz. Capturing narrower spectral width features requires slower frequency slew rates without Brownian motion degrading the measurement, to avoid excessively high A-D converter rates which will greatly increase the cost of the system. Slew rates <1GHz/usec may be required and spectral features less than 1 MHz full width at half maximum may be resolved.

Inventors also include liquids, solids, gases, plasmas, biological samples and other materials or forms of matter within our definition of sample. The present invention can be used for example to profile an atomic lineshape through characterization of the absorption for a gas, which may have a FWHM on the order of several MHz.

A preferred wavelength range for the present invention of a system to characterize spectral responsivity is one that comprises wavelengths within the C-band of optical communications, defined as 1530-1565nm. This is an important range for characterizing optical components. Other preferred ranges are ranges of absorption for important elements such as Rubidium, strontium, aluminum, ytterbium, cesium, and other elements used for atomic clocks and quantum computing applications.

Another embodiment of the present invention includes a fiber optic sensing system incorporating a wavelength swept laser emission from a tunable VCSEL with no moving intra-cavity parts, reducing Brownian motion noise to essentially zero. Under these conditions, the maximum interferometer delay will be determined by the intrinsic laser linewidth. For a typical fixed wavelength VCSEL linewidth of 2 MHz, the maximum interferometer delay will be about 100 meters in optical fiber, as represented by the horizontal dashed line 315 near the top of FIG. 2C. Narrower linewidth VCSELs can produce larger interferometer delays and longer sensing distances. Inventors note that if Brownian motion is not zero but sufficiently reduced in a MEMS-VCSEL, such as in the electro-thermally tuned device of FIGS. 5 and 6, then 100-meter interferometer delay is already possible with a 1 GHz A-D converter, as can be seen be extrapolating the yellow curve in FIG. 10. Reducing Brownian motion to zero, however, would enable operation at arbitrarily slow frequency slew rates.

The challenge of using a tunable VCSEL with no moving parts is obtaining sufficient tuning range for OFDR. Some workers have demonstrated 23nm tuning of a 1550nm VCSEL with an intra-cavity liquid crystal, as described in B. Boisnard et al., "CW operation of a tunable 1550-nm VCSEL integrating liquid-crystal microcells, " IEEE Photonics Technol. Lett., vol. 32, no. 7, pp. 391-394, 2020*.* This device has never been applied to OFDR but will have insignificant Brownian motion. In an OFDR system according to the present invention, the airgap 30 of the MEMS-VCSEL 310 in Fig 3 can be replaced by a tunable liquid crystal, eliminating Brownian motion and enabling on the order of 100-meter interferometer delay at arbitrarily slow slew rates. Another type of tunable VCSEL with insignificant Brownian motion is a thermally tuned VCSEL tuned by bias current injection. Some workers have also demonstrated bias current tuning of VCSELs up to 10nm tuning range, as described in M. Kendrisic et al., "Exploring single-mode VCSEL wavelength tuning for low-cost 3D optical coherence tomography and OCT angiography, " Biomedical Optics Express, vol. 15, no. 8, pp. 4719-4736, 2024*.* Some workers have also applied bias current tuned VCSELs to distance ranging at distances of less than 10 meters, as described in T. Hariyama, P. A. Sandborn, M. Watanabe, and M. C. Wu, "High-accuracy range-sensing system based on FMCW using low-cost VCSEL, " Optics express, vol. 26, no. 7, pp. 9285-9297, 2018*,* but have not realized the potential of long distance ranging by slowing down the frequency slew rate, or maximized tuning range with thermal tuning. In an OFDR system according to the present invention, the MEMSVCSEL 310 in FIG. 3 can be replaced by a bias-current tuned VCSEL, to enable 100-meter or longer interferometer delay at arbitrarily slow slew rates. Another advantage of bias current tuning is that the reference interferometer 140 in FIG. 3 can be eliminated for some applications, since the tuning of bias current-tuned VCSELs can be made sufficiently repeatable that wavelength calibration or optical clocking is not necessary. This statement also applies to a system employing a liquid crystal tuned VCSELs as discussed above.

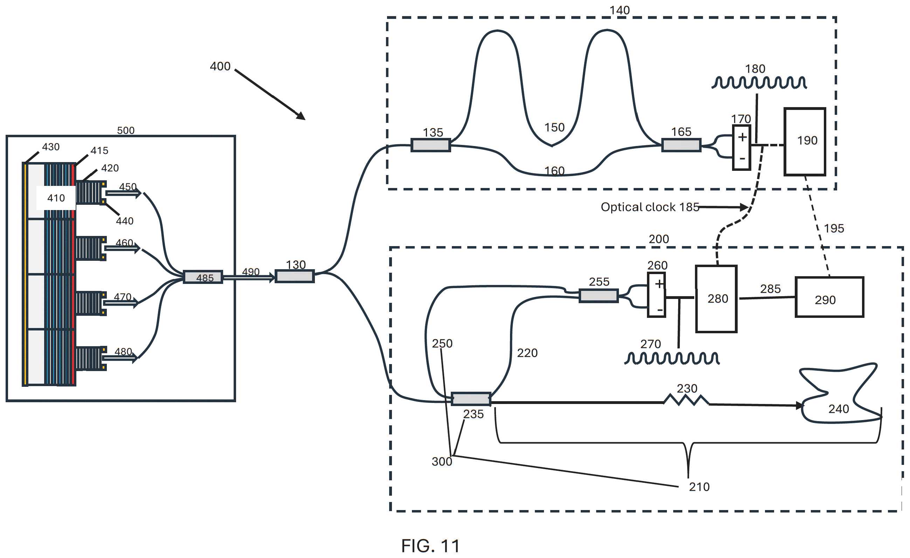

The tuning range limitation of bias-current tuned VCSELs can be overcome by using more than one VCSEL as has previously been disclosed for SS-OCT in Jayaraman, et al, Tunable Laser Array System, US Patent 9696132B2, July 4, 2017*,* hereafter Jayaraman 2017. The work of Jayaraman 2017 anticipates expanding tuning range or flexibility of operation for SSOCT through the use of arrays but does not consider the use of arrays for low Brownian motion, low-cost OFDR systems. FIG. 11 shows an OFDR system 400 according to the present invention, using a wavelength-swept source 500 comprising an array of N bias current tuned VCSELs, where N is >1, operating at N different wavelength ranges having N different center wavelengths. Each of the N different wavelength ranges may be overlapping with another of the N ranges, or the ranges may be completely non-overlapping. Each bias current tuned VCSEL of the array 500 comprises a fixed top mirror 420 and a fixed bottom mirror 410, on opposite sides of a gain region 415. Each of the VCSELs is tuned by bias current injection from an anode 440 to a cathode 430. The four VCSELs of the example wavelength swept source 500 emit individual wavelength swept beams 450, 460, 470, and 480, which are combined onto a common path through a coupler 485 to generate wavelength swept emission 490 that goes to the rest of the system 400. The combining of the four beams 450, 460, 470, and 480 can occur in optical fiber or in an integrated optics circuit or in free space. The choice of four VCSELs in FIG. 11 is intended to be an illustrative example and not limiting; any number more than one can be employed.

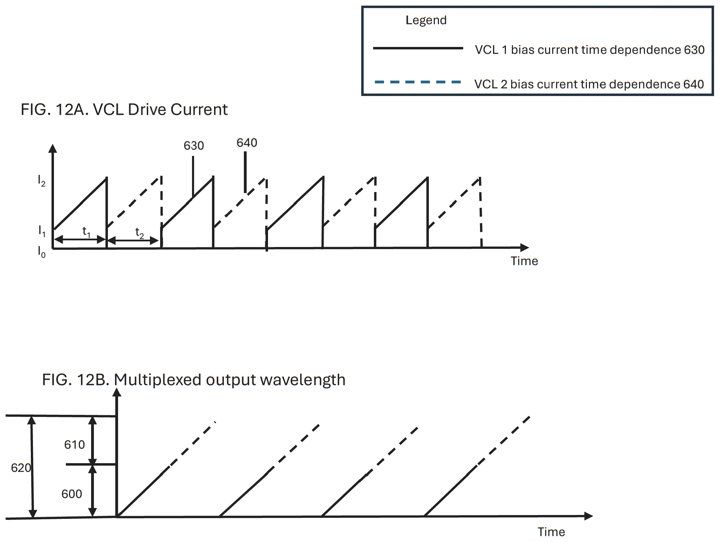

FIG. 12 shows an example of how two bias-current tuned VCSELs operating at two wavelength ranges can be driven to create a wider aggregate wavelength range. As shown in FIG. 12B, a first VCSEL VCL 1 operates over a first wavelength range 600, and a second VCSEL VCL 2 operates over a second wavelength range 610. Together, the tuning range 600 and tuning range 610 comprise an aggregate tuning range 620. FIG. 12A shows a time dependence 630 of bias current of VCL 1 and a time dependence 640 of the bias current of VCL 2. VCL 2 is off while VCL 1 is on and vice versa. Starting at the left of the time axis in FIG. 12A, VCL1 starts with a current I₀ below a threshold current of VCL1, and the current is stepped up to a current I₁ which is above the threshold current of VCL 1. The bias current is then ramped up over a time interval t₁ to a final value I₂. During ramping of the bias current over the interval t₁ the wavelength of VCL 1 is tuned over a wavelength range 600 shown in FIG. 12B. At the end of the interval t₁ VCL1 bias current is turned back below threshold to the value I₀ and the bias current of VCL2 is stepped up from I₀ to I₁, and ramped up to the bias current I₂ over a time interval t₂ which may be the same as or different from the time interval t₁. VCL2 is designed to operate over a different wavelength range 610 as shown in FIG. 12B. At the end of the interval t₂ the bias current of VCL2 is turned down to the value I₀. The values I₀, I₁, I₂ need not be the same for VCL1 and VCL2, but are represented as the same in FIG. 12A for simplicity. This sequence of bias current changes repeats periodically, such that only one of VCL1 and VCL2 are above threshold at any one time, and when the VCLs are multiplexed onto common path 490 as in FIG. 11, the aggregate tuning range 620 is a combination of range 600 and range 610. This approach can be extended to N bias-current tuned VCLs, where N is greater than one.

The bias current waveform shown in FIG. 12A is linear in time, but it can be any linear or nonlinear trajectory to create a desired linear or nonlinear wavelength trajectory. The VCSELs shown in the source 500 can also be thermally tuned by a separate integrated resistive heater while the bias current is held constant. The advantage of bias current tuning is higher frequency slew rate for SS-OCT applications, but OFDR applications can benefit from lower frequency slew rate needed to keep fringe frequencies low at long interferometer delays. Thus, although resistive heating can be slower, as shown by the frequency response in FIG. 6D, it is adequate and advantageous for OFDR applications. One advantage is independent control of power and wavelength. Another advantage of a resistive heater separate from bias current injection and integrated with a VCSEL with fixed mirrors, is that thermal isolation can be introduced between the heater and the quantum well region, enabling larger temperature swings and wavelength tuning, while still maintaining lasing. The term "fixed mirrors" is understood to mean a VCSEL with Brownian motion noise that is low enough to not appreciably affect the linewidth above an intrinsic linewidth. By intrinsic linewidth, inventors mean the linewidth of the VCSEL as calculated by the modified Schawlow-Townes expression, which is well-known to those skilled in the art of semiconductor lasers. This generally means the VCSEL does not have an intracavity airgap or intracavity suspended membrane or intracavity suspended mirror, but in some cases may include an airgap. Those skilled in the art understand that it is possible to have an airgap with insignificant Brownian motion if the layers around the airgap have sufficient mass. In the system 400 shown in FIG. 11, the reference interferometer 140 can be eliminated in many cases if a VCSEL with insignificant Brownian motion is employed as the wavelength swept source 310, since the repeatability of wavelength sweep is superior to VCSELs with substantial Brownian motion.

The maximum wavelength tuning achievable with bias current tuning is limited by thermal rollover of the VCSEL, which can be prevented by thermal isolation of the optical cavity from the quantum wells. An example of thermal isolation from resistive heating is shown by the airgap in FIG. 5A. To create a structure with low Brownian motion, the airgap could be replaced by a low thermal conductivity dielectric material like SiO2.

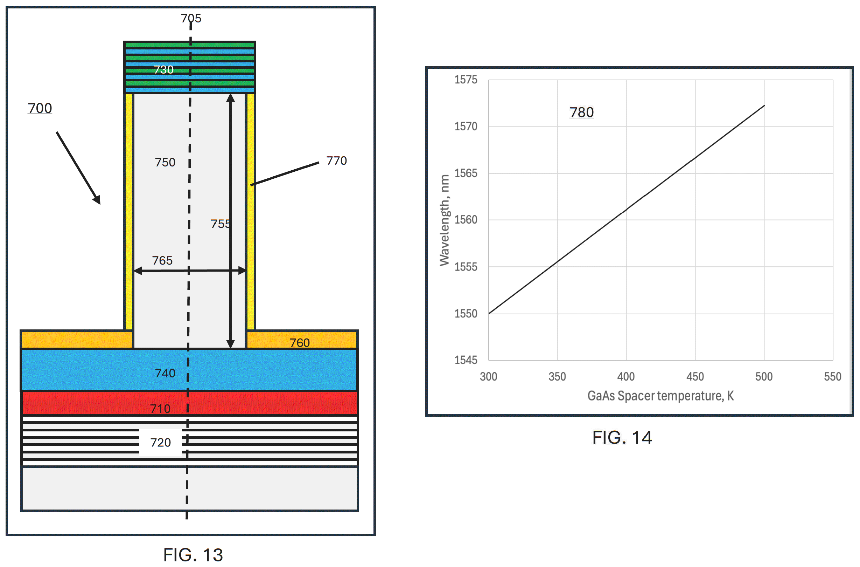

FIG. 13 shows key components of a thermally tuned narrow linewidth low Brownian motion 1550nm VCSEL structure 700, which exhibits laser oscillation along an optical axis 705, according to the present disclosure. The VCSEL 700 comprises a bottom GaAs/AlxOy mirror 720 wafer bonded to an InP-based active region 710 with one wavelength optical thickness, an SiO2 thermally isolating layer 740 of one wavelength optical thickness, bonded GaAs spacer 750 with an optical thickness 755 of 22.5 wavelengths measured along the optical axis 705, or approximately 10.3 microns, and a top deposited SiO2/TiO2 mirror 730. The spacer 750 also has a width 765 in a direction transverse to the optical axis 705. The width 765 is preferably in a range of 10-50 um, to enable efficient and rapid heating by a resistive heater 770. The GaAs cavity spacer serves to extend the cavity and narrow the linewidth relative to a conventional VCSEL. The thickness 755 of the spacer 750 is chosen to be as large as possible while maintaining a reasonable FSR-limited tuning range. The FSR of the example VCSEL cavity 700 is calculated as 30nm, which corresponds to an FSR-limited tuning range of about 30nm. A typical related art VCSEL has a total thickness of about 4 wavelengths. The VCSEL according the present disclosure in FIG. 13 has a cavity length that is therefore about 5.5 times the length of typical related art VCSELs. The linewidth of a semiconductor laser goes nominally as the inverse square of the length the cavity, so the VCSEL cavity 700 of FIG. 13 can be expected to have a linewidth that is about 1/30 of a conventional VCSEL. In combination with high reflectivity mirrors, which further increase photon linewidth and reduce cavity lifetime, the VCSEL of Fig 13 can be expected to have a linewidth of less than 100kHz. Thus, the VCSEL cavity 700 can be employed for interferometer delays longer than 1 km and sensing distances longer than 1 km. Since varying applications require varying linewidths, the example spacer thickness discussed here for spacer 750 is only illustrative and not limiting. The spacer can also be of any optically transparent material, though preferably of a semiconductor such as GaAs, InP, silicon, or Gallium Phosphide (GaP) since undoped semiconductor materials have high index >2.8 supporting long path delays, and low optical loss which also supports long path delays. The maximum spacer thickness is determined by the FSR-limited tuning range required and the limits of epitaxial growth. For example the spacer thickness could be doubled to 45 wavelengths, supporting FSR-limited tuning range of 15 nm and reducing linewidth by another factor of 4. The VCSEL cavity 700 is preferably optically pumped, since this minimizes intracavity loss and allows increased mirror reflectivity for reasonable output power, both of which increase photon lifetime and reduce linewidth. The spacer can also be as little as one micron in thickness, and still provide substantial linewidth narrowing, due to the inverse square relationship between linewidth and cavity length. Any spacer of refractive index times thickness product >2.8 wavelengths at an operating wavelength of the cavity 700 is deemed within the boundary of the present disclosure. Electrical pumping can also be employed, depending on the application. The VCSEL cavity 700 can also be combined with a semiconductor optical amplifier (SOA) to produce narrow linewidth in conjunction with high output power.

The VCSEL 700 in FIG. 13 also includes a resistive heater 770 that is contacted by a heater electrode 760. The device is shown in cross-section and the resistive heater 770 could cover the walls of a circular or rectangular cylinder or only be applied to a portion of the outside of an etched cylindrical feature. The purpose of the resistive heater 770 is to heat the spacer 750. The thermally isolating layer 740 isolates the active region 710 from the heat of the spacer 750, enabling lasing operation to be sustained.

FIG. 14 shows a calculated tuning plot 780 of the VCSEL cavity 700 as a function of the temperature of the cavity spacer 750. As shown, a temperature change of 200K in the spacer layer 750 effects about a 22nm shift in the lasing wavelength of the VCSEL cavity 700. This tuning mechanism can operate in the few Hz or 1 kHz range, which is too slow for SS-OCT, but ideal for OFDR applications. For example, the VCSEL 700 can be employed for >1 km sensing, using a 1550nm VCSEL with 20 nm tuning range and a wavelength repetition rate of 40Hz, which produces a fringe frequency of about 487 MHz, which can be sampled by a 1 GHz A-D converter. Arbitrarily slow sweep rates with lower speed A-D converters are possible, since the VCSEL cavity 700 has insignificant Brownian motion noise.

While the present disclosure has been described at some length and with some particularity with respect to the several described embodiments, it is not intended that it should be limited to any such particulars or embodiments or any particular embodiment, but it is to be construed with references to the appended claims so as to provide the broadest possible interpretation of such claims in view of the prior art and, therefore, to effectively encompass the intended scope of the disclosure. Furthermore, the foregoing describes the disclosure in terms of embodiments foreseen by the inventor for which an enabling description was available, notwithstanding that insubstantial modifications of the disclosure, not presently foreseen, may nonetheless represent equivalents thereto.

Further, the disclosure includes examples according to the following clauses.
Clause 1. A system for optical frequency domain reflectometry (OFDR) configured to interrogate a property of an object or of a structure along a sensing optical path, said system comprising:
   a tunable vertical cavity laser (tunable VCSEL) having an optical cavity with a free spectral range and including a top mirror, an active region, and a bottom mirror, said vertical cavity laser emitting periodically wavelength swept laser radiation, having a center wavelength, a tuning range, a frequency slew rate, and a sweep repetition rate,
   wherein said periodically wavelength swept laser radiation is directed to a sensing interferometer comprising a sensing optical path having a sensing optical path length and a reference optical path having a reference optical path length, said reference path optical length differing from said sensing optical path length by a sensing interferometer optical path difference and, wavelength swept laser radiation traversing said reference optical path is interfered with wavelength swept laser radiation traversing said sensing optical path on an optical detector generating interference fringes having a maximum fringe frequency, and said frequency slew rate is less than 5GHz/usec.
Clause 2. The system of clause 1, further comprising a reference Mach-Zehnder interferometer (MZI) with a reference interferometer optical path difference.
Clause 3. The system of clause 2, wherein said reference interferometer optical path difference is less than said sensing interferometer optical path difference.
Clause 4. The system of any of clauses 1-3, further comprising at least one analog to digital converter which digitizes said interference fringes.
Clause 5. The system of any of clauses 1-4, wherein said tunable VCSEL is a MEMS-VCSEL wherein said top mirror is suspended above a tunable airgap.
Clause 6. The system of any of clauses 1-5, wherein said tunable VCSEL has a slew rate noise probability density function with a single-sided standard deviation of less than 1/3 of said frequency slew rate.
Clause 7. The system of any of clauses 1-6, wherein said frequency slew rate is less than 1GHz/usec.
Clause 8. The system of any of clauses 1-7, wherein said free spectral range is less than 5% of said center wavelength.
Clause 9. The system of any of clauses 1-8, wherein said center wavelength is between 1500nm and 1600nm.
Clause 10. The system of any of clauses 1-9, wherein said maximum fringe frequency is less than 1.3GHz.
Clause 11. The system of any of clauses 1-9, wherein said maximum fringe frequency is less than 500MHz.
Clause 12. The system of any of clauses 1-9, wherein said maximum fringe frequency is less than 130MHz.
Clause 13. The system of any of clauses 1-12, wherein said sensing interferometer optical path difference exceeds the equivalent of 10 meters in optical fiber.
Clause 14. The system of any of clauses 1-13, wherein said sensing interferometer optical path difference exceeds the equivalent of 50 meters in optical fiber.
Clause 15. The system of any of clauses 1-14, wherein said sensing interferometer optical path difference exceeds the equivalent of 1 kilometer in optical fiber.
Clause 16. The system of any of clauses 1-15, wherein said property includes strain induced in a section of optical fiber along said sensing optical path.
Clause 17. The system of clause 5, wherein said suspended mirror is tuned by electrothermal tuning of a resistive heating element integrated with said suspended mirror.
Clause 18. The system of any of clauses 1-17, wherein said vertical cavity laser is optically pumped by a pump laser emitting at a pump wavelength.
Clause 19. The system of clause 18, wherein said pump wavelength is in a range of 900nm to 1350nm.
Clause 20. The system of any of clauses 1-19, wherein said vertical cavity laser is electrically pumped.
Clause 21. The system of any of clauses 1-20, further comprising a semiconductor optical amplifier.
Clause 22. The system of any of clauses 1-21, wherein said system comprises a substantial portion of a LIDAR system.
Clause 23. The system of any of clauses 1-22, wherein said tunable VCSEL is tuned by thermal tuning.
Clause 24. The system of clause 23, wherein said thermal tuning is accomplished by bias current tuning.
Clause 25. The system of clause 23, wherein said thermal tuning is accomplished by resistive heating separate from bias current injection.
Clause 26. The system of clause 23, wherein said thermal tuning is accomplished by a resistive heater integral with a suspended mirror.
Clause 27. The system of any of clauses 1-26, wherein said tunable VCSEL is tuned by an intra-cavity liquid crystal.
Clause 28. A system for optical frequency domain reflectometry (OFDR) configured to interrogate a property of an object or of a structure along a sensing optical path, the system comprising:
   a light source emitting periodically wavelength-swept radiation having a source center wavelength, a tuning range, a frequency slew rate, and a sweep repetition rate,
   wherein said light source comprises N wavelength-swept vertical cavity lasers (VCSELs) emitting N tunable VCSEL outputs having N wavelength trajectories having N different VCSEL center wavelengths, where N is greater than one, and a coupler for combining said N tunable VCSEL optical outputs onto a common optical path to create said periodically wavelength-swept radiation, and
   said periodically wavelength swept laser radiation is directed to a sensing interferometer comprising a sensing optical path having a sensing optical path length and a reference optical path having a reference optical path length, said reference path optical length differing from said sensing optical path length by a sensing interferometer optical path difference and said wavelength swept laser radiation traversing said reference optical path is interfered with wavelength swept laser radiation traversing said sensing optical path on an optical detector generating interference fringes having a maximum fringe frequency.
Clause 29. The system of clause 28, wherein said frequency slew rate is less than 5GHz/usec.
Clause 30. The system of any of clauses 28-29, wherein at least one of said N tunable VCSELs is tuned by bias current injection.
Clause 31. The system of any of clauses 28-30, wherein at least one of said N tunable VCSELs is tuned by resistive heating separate from bias current injection.
Clause 32. The system of any of clauses 28-31, wherein said source center wavelength is in a range of 1500-1600nm.
Clause 33. The system of any of clauses 28-32, wherein said frequency slew rate is less than 1 GHz/usec.
Clause 34. A tunable vertical cavity laser comprising a cavity with a top mirror, a bottom mirror, an active region, an intracavity spacer layer of index thickness product greater than 2.8 wavelengths, and an integrated heater capable of heating said intra-cavity spacer layer.
Clause 35. The tunable vertical cavity laser of clause 34, wherein said intracavity spacer layer has a thickness exceeding 5 microns.
Clause 36. The tunable vertical cavity laser of any of clauses 34-35, wherein said intracavity spacer comprises at least one of the list consisting of GaAs, InP, silicon, and GaP.
Clause 37. The tunable vertical cavity laser of any of clauses 34-36, further comprising a thermal isolation layer between said active region and said cavity spacer.
Clause 38. The tunable vertical cavity laser of clause 37, wherein said thermal isolation layer comprises at least one of the list consisting of silicon dioxide, silicon nitride, and air.
Clause 39. The system of clause 1, wherein said tunable vertical cavity laser is the tunable vertical cavity laser of clause 34.
Clause 40. The system of clause 39, wherein said frequency slew rate is less than 0.1 GHz/usec.
Clause 41. The system of any of clauses 39-40, wherein said sensing interferometer optical path difference is greater than one kilometer.
Clause 42. A system for characterizing a spectral response of a sample, said system comprising a MEMS-VCSEL having an optical cavity with a free spectral range and including a suspended top mirror, an active region, and a bottom mirror, said MEMS-VCSEL emitting wavelength tuned laser radiation having a center wavelength, a wavelength tuning range, and a maximum frequency slew rate less than 5GHz/usec.
Clause 43. The system of clause 42, wherein said frequency slew rate is less than 1 GHz/usec.
Clause 44. The system of any of clauses 42-43, wherein said sample is a photonic integrated circuit.
Clause 45. The system of any of clauses 42-44, wherein said sample comprises a component used in optical communications.
Clause 46. The system of any of clauses 42-45, wherein said sample is a gas.
Clause 47. The system of any of clauses 42-46, wherein said spectral response corresponds to an atomic lineshape.
Clause 48. The system of any of clauses 42-47, wherein said wavelength tuning range includes wavelengths within the optical communications C-band from 1530nm to 1565 nm.
Clause 49. The system of any of clauses 42-48, wherein said free spectral range is less than 5% of said center wavelength.
Clause 50. The system of any of clauses 42-49, further comprising an optical detector configured to detect at least one of said wavelength tuned laser radiation transmitted, reflected, and scattered from said sample.
Clause 51. The system of any of clauses 42-50, further comprising signal processing to reconstruct said spectral response.
Clause 52. The system of any of clauses 42-51, wherein said spectral response comprises at least one feature with a full width at half maximum less than 100 MHz.
Clause 53. The system of any of clauses 42-52, wherein said spectral response comprises at least one feature with a full width at half maximum of less than 10 MHz.
Clause 54. The system of any of clauses 42-53, wherein said spectral response comprises at least one feature with a full width at half maximum of less than 1 MHz.

## Claims

1. A system for optical frequency domain reflectometry (OFDR) configured to interrogate a property of an object or of a structure along a sensing optical path, said system comprising:
a tunable vertical cavity laser (tunable VCSEL) having an optical cavity with a free spectral range and including a top mirror, an active region, and a bottom mirror, said vertical cavity laser emitting periodically wavelength swept laser radiation, having a center wavelength, a tuning range, a frequency slew rate, and a sweep repetition rate,
wherein said periodically wavelength swept laser radiation is directed to a sensing interferometer comprising a sensing optical path having a sensing optical path length and a reference optical path having a reference optical path length, said reference path optical length differing from said sensing optical path length by a sensing interferometer optical path difference and, wavelength swept laser radiation traversing said reference optical path is interfered with wavelength swept laser radiation traversing said sensing optical path on an optical detector generating interference fringes having a maximum fringe frequency, and said frequency slew rate is less than 5GHz/usec.

2. The system of claim 1, further comprising a reference Mach-Zehnder interferometer (MZI) with a reference interferometer optical path difference, and wherein said reference interferometer optical path difference is less than said sensing interferometer optical path difference.

3. The system of claim 1 or 2, further comprising at least one analog to digital converter which digitizes said interference fringes.

4. The system of any of claims 1-3, wherein said tunable VCSEL is a MEMS-VCSEL wherein said top mirror is suspended above a tunable airgap.

5. The system of any of claims 1-4, wherein the system includes at least one of following:
wherein said tunable VCSEL has a slew rate noise probability density function with a single-sided standard deviation of less than 1/3 of said frequency slew rate;
wherein said frequency slew rate is less than 1GHz/usec;
wherein said free spectral range is less than 5% of said center wavelength;
wherein said center wavelength is between 1500nm and 1600nm;.
wherein said maximum fringe frequency is less than 1.3GHz.
wherein said sensing interferometer optical path difference exceeds the equivalent of 10 meters in optical fiber; and
wherein said sensing interferometer optical path difference exceeds the equivalent of 1 kilometer in optical fiber.

6. The system of any of claim 1-5, wherein said property includes strain induced in a section of optical fiber along said sensing optical path.

7. The system of claim 4, wherein said suspended mirror is tuned by electrothermal tuning of a resistive heating element integrated with said suspended mirror.

8. The system of any of claims 1-7, wherein said vertical cavity laser is optically pumped by a pump laser emitting at a pump wavelength.

9. The system of claim 8, wherein said pump wavelength is in a range of 900nm to 1350nm.

10. The system of any of claims 1-9, wherein said vertical cavity laser is electrically pumped.

11. The system of any of claims 1-10, further comprising a semiconductor optical amplifier.

12. The system of any of claims 1-11, wherein said system comprises a substantial portion of a LIDAR system.

13. The system of claim 1, wherein said tunable VCSEL is tuned by thermal tuning, and
wherein the system includes at least one of following:
wherein said thermal tuning is accomplished by bias current tuning;
wherein said thermal tuning is accomplished by resistive heating separate from bias current injection; and
wherein said thermal tuning is accomplished by a resistive heater integral with a suspended mirror.

14. The system of any of claims 1-13, wherein said tunable VCSEL is tuned by an intra-cavity liquid crystal.

15. A tunable vertical cavity laser comprising a cavity with a top mirror, a bottom mirror, an active region, an intracavity spacer layer of index thickness product greater than 2.8 wavelengths, and an integrated heater capable of heating said intra-cavity spacer layer.
